# EUROPEAN PATENT SPECIFICATION

(11) **EP 2 482 303 B1**
(45) Date of publication and mention of the grant of the patent: **06.04.2016**
(21) Application number: 12151173.7
(22) Date of filing: 13.01.2012
(51) Int. Cl.: H01J 37/302, H01J 37/305, C23C 14/16, C23C 14/32

(54) **Deposition apparatus and methods**
Abscheidungsvorrichtung und Verfahren
Appareil de dépôt et procédés

(30) Priority: 28.01.2011 US 201113016223
(43) Date of publication of application: 01.08.2012
(73) Proprietor: United Technologies Corporation, Hartford, CT 06101 (US)
(72) Inventor: Kuzmichev, Anatoly, 02192 Kiev (UA); Belousov, Igor V., 08650 Kyiv's Region (UA); Kononenko, Yuriy G., 01021 Kyiv (UA); Mullooly, John F., Oklahoma City OK 73150 (US)
(74) Representative: Hull, James Edward

(56) References cited:
- JP-A- H09 143 698
- JP-A- S62 109 972
- US-A1- 2010 155 224

## Description

### BACKGROUND

The disclosure relates to deposition of coatings via ion-enhanced electron beam physical vapor deposition (IE-EBPVD). More particularly, the disclosure relates to deposition of aerospace coatings including dimensional restorative coatings.

The components of gas turbine engines are subject to wear and damage. Even moderate wear and damage of certain components may interfere with optimal operation of the engine. Particular areas of concern involve the airfoils of various blades and vanes. Wear and damage may interfere with their aerodynamic efficiency, produce dynamic force imbalances, and even structurally compromise the worn/damaged parts in more extreme cases. Various techniques have been proposed for restoration of worn or damaged parts of gas turbine engines. US Patent No. 7509734 (US '734) to Memmen et al. discloses an ion enhanced electron beam physical vapor deposition (IE-EBPVD) system. As is discussed further below, that system or a similar system may serve as the baseline for modification according to the principles herein.

Additionally, IE-EBPVD has been proposed for use in non-restorative aerospace coatings. One example is found in US Patent No. 4109061 which discloses deposition of a MCrAlY-type (where M is Ni and/or Co) coating such as is used as a bondcoat for a thermal barrier coating (TBC) system.

As is discussed further below, coating processes, including IE-EBPVD, have suffered various problems/limitations which present themselves as competing considerations. For example, in general, a broad deposition footprint, a high deposition rate, and a high quality of deposition may be desirable. However, these may compete adversely with each other. Particularly, attempts at achieving high deposition rate are associated with coating defects including spitting. Spitting is generally associated with liquid droplets impacting the substrate/workpiece and causing microstructural discontinuities. It is believed that high electron beam power causes microbursts of vapor at the melt pool. The microbursts tend to eject liquid which forms spits.

JP62-109972 discloses an ion plating device according to the preamble of present claim 1.

US2010/0155224 A1 discloses multi-component deposition.

JP09-1433698 discloses a continuous ion plating device. 1

According to the invention, there is provided an apparatus according to independent claim 1 and a method according to independent claim 11.

In various implementations, the first means may comprise a first anode. The first anode may fully encircle a flowpath from the deposition material source to the workpiece. The first means may comprise a circular ring. The second means may comprise one or more electrodes. The deposition material may comprise an MCrAlY or a Ti-based alloy (more narrowly, may consist essentially of or consist of such MCrAlY or Ti-based alloy).

The details of one or more embodiments are set forth in the accompanying drawings and the description below. Other features, objects, and advantages will be apparent from the description and drawings, and from the claims.

### BRIEF DESCRIPTION OF THE DRAWINGS

FIG. 1 is a partially schematic view of a first ion-enhanced physical vapor deposition apparatus.
FIG. 2 is a transverse schematic view of the positional relationships between an anode of a second deposition apparatus and a substrate/workpiece.
FIG. 3 is a schematic transverse view of the positional relationships between anodes of a third deposition apparatus and a substrate.

Like reference numbers and designations in the various drawings indicate like elements.

### DETAILED DESCRIPTION

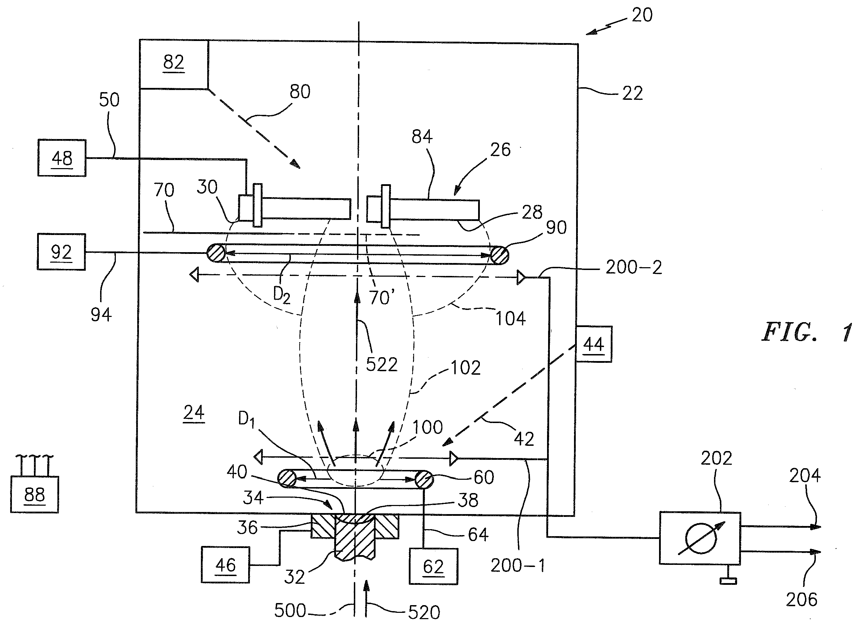

FIG. 1 shows an ion-enhanced EBPVD (IE-EBPVD) apparatus 20 for performing the foregoing deposition. The apparatus includes a vacuum chamber 22 having an interior 24. A workpiece 26 (e.g., a turbine engine part) having a surface portion 28 for receiving deposition is positioned in the chamber interior and held by a fixture 30. The chamber may have various additional features (not shown) such as an integral vacuum pump for pumping down the chamber, a load lock chamber and a sting/actuator for introducing and removing the workpiece 26, and various sensors.

The exemplary dimensional restoration deposition (e.g., of a damaged/worn turbine engine blade or other workpiece) is performed at a pressure between 10⁻¹ and 10⁻⁴ Pa, more narrowly, approximately (5-10)×10⁻³Pa. The exemplary deposition rates are between 10 and 100 micrometers per minute, more narrowly, between 10 and 50 micrometers per minute, with an exemplary approximately 20 micrometers per minute. The localized deposition may build up to essentially any depth in one or more stages. In an exemplary dimensional restoration situation, the separate stages may be characterized by some combination of intervening machining or repositioning of the component relative to the vapor source. Individual stages may well deposit material to depths over 2mm, over 5mm, or even more.

The deposition material may, at least in part, come from an ingot 32 which may be progressively and continuously inserted into the chamber 22 along an axis 500 in insertion direction 520 through a chamber port 34. Exemplary ingot material is chosen to achieve a desired chemistry for the resulting deposited material. For example, it may be desirable that the deposited material has the same chemistry as the basic substrate material of the workpiece being repaired. Where the latter is a pure elemental material, the former may be likewise. With alloys, however, there may need to be chemistry variations for several reasons. The reasons may vary depending upon the chemistry of the alloy, the structure of the deposition apparatus, and the operational parameters of the deposition apparatus. For example, the lightest vaporized alloy elements (e.g., aluminum in a titanium-aluminum-vanadium alloy and vapor mixture) may be forced toward the periphery of the vapor stream by the heavier elements (e.g., the titanium). To the extent that the workpiece is aligned with the center of the stream, the deposited material will tentatively reduce concentrations of lighter elements relative to their original concentration in the ingot. Accordingly, to achieve a desired deposition material composition, the ingot may have a higher concentration of lighter elements. Thus, to deposit an exemplary Ti-6Al-4V material, a Ti-8Al-4V ingot may be utilized. Alternative mechanisms may cause depletion of specific components. These may include failure of the components to reach the workpiece and may also include ejection of components from deposited coating during deposition.

Appropriate seals (not shown) may be provided to prevent leakage around the ingot. Alternatively, the ingot and its progressive movement actuator (not shown) may be located within the chamber 24. An inboard end of the ingot becomes positioned within a crucible 36 along a bottom one of the walls defining the chamber. A molten pool (melt pool) 38 of metal from the ingot is formed within the chamber and has a surface or meniscus 40. The ingot is melted to provide the pool via an electron beam 42 emitted from an electron gun 44 which may be positioned within or without the chamber to direct the beam to the inboard ingot end/pool. The crucible serves to contain the pool. The crucible is advantageously cooled to keep it from melting (e.g., by passing a cooling fluid such as water through an external cooling jacket (not shown)). In the exemplary embodiment, the crucible is an electromagnetic crucible unit having a cylindrical winding around the ingot powered by a power supply 46. The energized winding generates a magnetic field within and above the molten pool 38. Exemplary magnetic field inductions are 0.003-0.06 T. The magnetic field serves to help focus the electron beam 42, which may have been defocused by the ionizing discharge plasma and the magnetic field of the discharge current, so as to enhance the evaporation rate. The magnetic field also helps stabilize the ionizing discharge on the surface 40 by preventing the movement of discharge cathode spots to a crucible periphery and, thereby, avoiding vacuum arc burning on the crucible body. The magnetic field helps control the discharge plasma parameters by affecting the ionization degree and spatial distribution. The magnetic field also influences rotational flow of metal in the pool 38. This flow helps enhance mixing of the components of the molten metal and decreases metal spitting. The rotation of liquid metal is a result of the interaction of electrical current in the metal, caused by the electron beam and ionizing discharge, with the magnetic field of the winding. The rotation also enhances evaporation efficiency due to decreased heat transfer to the cooled crucible wall.

The heating by the electron beam is effective to vaporize the metal in the pool. To draw positively charged metal ions from the vapor to surface 28, the workpiece 26 is subjected to a negative bias. A pulse modulator 48 is coupled to the workpiece 26 via a line/conductor 50. The bias voltage may have a square pulse wave form characterized by a pulse repetition frequency F_{b} (pulse rate), a pulse width τ_{b}, duty cycle D_{b}, and a peak voltage U_{b}. D_{b} = τ_{b}xF_{b}. Alternate bias voltage wave forms may be used (e.g., sinusoidal). With a non-modulated direct current bias, arc discharge (arcing) would likely occur on the surface 28, especially in the first few seconds of deposition. Such discharge may damage the surface. Pulse modulation of the bias voltage may effectively suppress such arcing. Decreasing of pulse width decreases the probability of arcing as arc formation needs sufficient time (e.g., from one hundred to several thousands of microseconds). Even if an arc discharge occurs, the break (pause) between bias pulses would quickly interrupt the discharge.

Bias voltage parameters may vary greatly based upon the nature of the apparatus, the nature of the deposition material, the size of the workpiece (mass and linear dimensions), and the like. The exemplary peak voltage is a negative voltage in the range of 50-10,000 V. The exemplary pulse repetition frequency is in the range of 0.05-150 kHz. The exemplary pulse width is ≥ about 5 µsec. Such pulse width may be selected because only a few of the ions would reach the workpiece with full energy if there were shorter pulses of like voltage. Ions generated from vapor species of metal atoms need a relatively long time (roughly proportional to their mass) to pass across the space charge shell around the workpiece to reach the workpiece from the vapor plasma. The shell separates the vapor plasma from the workpiece with negative potential. The metal ions are accelerated by the bias voltage. The time needed for the ions to cross the shell (e.g., about 1 µs) would practically need to be shorter than the pulse width τ_{b}. The bias voltage parameters may be changed dynamically during the deposition process to control parameters of deposition, especially the temperature of the workpiece. The process may begin with relatively high U_{b} and D_{b} with the value then decreasing to keep the workpiece temperature within a target range. The values may be increased if the temperature reaches or falls below the low end of such range. In an exemplary implementation, only the duty cycle is varied during operation. For example, during initial interval of an exemplary 0.5-2.0 minutes the duty cycle may be approximately 0.9. The duty cycle is then decreased to a value of approximately 0.1-0.4 for several minutes to avoid overheating. The duty cycle may incrementally be increased back toward the 0.9 value as appropriate to maintain the operating temperature within the target range. The pulse modulator 48 (FIG. 1) may include a modulation electronic tube as in US '734. The electronic tube (e.g., a triode, tetrode, or the like) serves as a fast switch device periodically connecting the primary DC power source of negative polarity (not shown in FIG. 1) to the workpiece 28 and thereby generating the negative bias voltage pulses. The primary DC power source voltage can be regulated to determine the peak value of the bias voltage. The pulse modulator may also contain a generator (not shown) of control pulses applied to the control grid of the electronic tube. The control pulse parameters determine the parameters of the bias voltage pulses (F_{b}, τ_{b}, D_{b}, U_{b}). Current and voltage probes (not shown) may be coupled to the electronic tube and provide outputs which may be monitored as via an oscilloscope (not shown) or other electronic means (e.g., a special-purpose computer). Such monitoring may serve to verify normal operation of the pulse modulator. Alternative voltage modulators may be used to generate the bias voltage (e.g., based on thyratrons, thyristors, transistors, and step-up transformers). However, electronic tube modulators may provide a desired combination of robustness and control of current delivered to the workpiece to limit sparking and arcing. An aspect of exemplary electronic tube modulators is that the tube anode current is determined mainly by voltages of the control grid (and by the screen grid in tetrodes and pentodes) and weakly by the anode voltage. Therefore, in the case of arcing on the workpiece the tube anode voltage may sharply rise and become equal to the primary anode DC power source voltage while the control grid voltage remains the same. Accordingly, the anode current (that is the workpiece current) will be practically the same as without arcing. Thus, the anode current may slightly increase and this slightly increased current is the maximum current to the work piece during arcing. Thus, the electron tube acts to automatically limit the load current. Alternative modulation devices may have difficulty limiting current in the load circuit and may therefore need a very fast acting safeguard system for turning off current in the event of arcing on the workpiece surface.

To maintain an ionizing discharge along a vapor/ion flowpath 522 from the pool 38 to the surface 28, a first ionizing anode electrode 60 (e.g., a ring at least partially surrounding the path 522) is connected to a power supply 62 via a line/conductor 64. The discharge may provide the necessary degree of ionization of evaporated species. The degree of ionization may be characterized by an ion current density jᵢ on the deposition surface. Exemplary jᵢ are 1-50mA/cm², more narrowly, approximately 2-10mA/cm2. This may be associated with an exemplary discharge current of 50-500A and associated discharge voltage of 5-50V. For deposition of titanium alloys, an exemplary associated discharge voltage Uₐ₁ is 8-20V. A pulse modulator (not shown) may be provided between the power supply 62 and ring 60 to modulate the ionizing discharge. The ionizing discharge may have a pulse rate (pulse repetition frequency) Fₐ₁, a pulse width τₐ₁, a duty cycle Dₐ₁=τₐ₁×Fₐ₁, and a peak current Iₐ₁.

Modulation of the ionizing discharge may have several effects. Decreasing the duty cycle shortens discharge on-time which is associated with the period during which the discharge affects (e.g., defocuses) the electron beam 42. Such defocusing may decrease the evaporation rate. The modulation may stabilize the ionizing discharge by preventing jumping of a discharge from the surface of the pool to the crucible body periphery to prevent vacuum arc burning on the crucible body. Such burning is quite disadvantageous because the crucible material may provide undesirable impurities in the deposited materials. The main mechanism of vacuum arc excitation on the conductive surface of the crucible body is the electrical explosion of sharp microscopic irregularities due to their heating by the field emission current (e.g., for which the plasma of the ionizing discharge serves as an anode). Sufficient heating requires a sufficient interval. The pulsing of the ionizing discharge provides periodic interruption of the heating of and field emission from the crucible microscopic irregularities to permit sufficient cooling to ensure a stable discharge. The modulation parameters are chosen to provide a desired current density on the deposition surface of the workpiece with desired ionizing discharge stability in view of permissible effects upon the electron bean and evaporation rate. Exemplary modulation parameters involve a frequency Fₐ₁ in the range of 1-10,000Hz, more narrowly 100-1,000Hz, and a duty cycle Dₐ₁ in the vicinity of 0.5-0.99, more narrowly 0.8-0.99. One or more discharge pulse parameters may be varied during deposition process. For example, duty cycle may be gradually decreased during some period after the beginning of the deposition process. A decrease to zero might provide a soft transition from ion-enhanced EBPVD to conventional EBPVD. Various wave forms may be used alternatively to the square pulse.

A shutter 70 may have a first position (solid line) clear of the flowpath 522 and a second position (broken line) 70' blocking the flowpath 522. The shutter may be positioned downstream of the anode ring 60 along the flowpath 522. The shutter may be in the second position 70' during preparation as the apparatus is brought up to initial target operating conditions. During this stage, the ingot material is melted to form the pool, the ionizing discharge is established, the negative bias voltage is applied to the workpiece, and the workpiece may be preheated. The workpiece 26 may be preheated via an electron beam 80 delivered by a second electron gun 82 to impact a non deposition surface portion 84 of the workpiece. The preheating may serve to clean the deposition surface by pyrolysis and desorption of surface impurities. This may enhance binding and adhesion of deposited material and avoid thermal shock during the initial stages of deposition. In an exemplary embodiment, the preheating may be varied to provide a gradual increase in workpiece temperature effective to achieve a desired rate of vapor, thermo-desorbed from the workpiece, in view of equipment parameters limiting the evacuation of such vapor while avoiding unacceptable oxidation of the workpiece. Preheating parameters may depend greatly upon the geometry and mass of the workpiece. The exemplary preheating brings the workpiece to a temperature no greater than the maximum operational target temperature, and, more particularly, generally within the operational target temperature range. With the parameters in the initial target range, the shutter is opened to expose the workpiece to deposition. During deposition, the workpiece may be heated by the second electron gun 82, by the ion bombardment, by heat radiation (e.g., from the melted metal in the pool), and by the latent heat of the atoms condensing in the deposition. The second electron gun is turned off if the temperature exceeds the maximum of an operational target range and may be turned off so long as the temperature is within the target range. It may, however, be switched back on if the temperature falls below a minimum of the target range. For example, if the deposition rate is decreased toward the end of a deposition process, the electron gun may need to be turned back on during the decreased rate stage.

Operation is controlled by a control system (controller) 88 which may receive user inputs from input devices (not shown, e.g., switches, keyboard, or the like) and sensors (not shown). The controller is coupled to the controllable system components (e.g., pumps, valves, power supplies, EB guns, actuators, and the like) via control lines (e.g., hardwired or wireless communication paths). The controller may include one or more: processors; memory (e.g., for storing program information for execution by the processor to perform the operational methods and for storing data used or generated by the program(s)); and hardware interface devices (e.g., ports) for interfacing with input/output devices and other system components.

The foregoing description of a single-anode system may represent a baseline system from which the present system is formed as a reengineering/remanufacturing. Whereas the first anode 60 is relatively upstream along the flowpath 522, a second anode 90 is added relatively downstream. The second anode 90 is coupled to the positive pole of a power source 92 via a conductor 94 to apply a positive bias voltage Uₐ₂ to the second anode. The exemplary second anode 90 is, more narrowly, positioned in a last third of an axial distance between the pool surface 40 and the substrate deposition surface 28, yet more narrowly, a last tenth. This may be contrasted with the position of the first anode 60 well upstream (e.g., in the upstream third but, more particularly, at an absolute axial distance of 1-10cm, more narrowly, 2-3cm from the pool surface).

In operation, the first anode 60 encourages formation of an initial arc discharge plasma 100. This plasma diffuses with the flow in a pattern 102 extending toward/to the substrate surface 28. With the single-anode system, ion current density distribution has a pronounced maximum just above the crucible. This leads to non-uniform conditions (to non-uniform ion enhancing and, as consequence, non-uniform coating properties) over the coating surface of a large substrate. Increasing the crucible-to-substrate distance may make more uniform the ion current density distribution but it leads to decreasing the deposition rate and ion current density value. Increasing evaporating electron beam power to overcome the low deposition rate at larger crucible-to-substrate distances causes, as noted above, splashing of melted metal in a crucible and spit deposition. Additionally, mean energy of electrons in the plasma of pattern 102 substantially decreases with axial distance from the initial arc discharge plasma 100 mainly due to collisions with vapor specimens. Therefore, vapor ionization may be limited/insignificant above the first anode. This effectively limits the ion current to the substrate because increasing arc discharge current to the first anode may provoke cathode arcs at the crucible body periphery. Thus, there is a trade-off between high-rate spit-free deposition and high-rate large surface coating deposition.

The second anode 90 provides additional ionization and generates a spreading secondary plasma 104 in a wide space between the crucible and the substrate close to the deposition surface 28. This is done by creating an electrical field that accelerates electrons from the freely diffusing plasma 102 and increases their mean energy to the level of effective vapor ionization. As is discussed below, this may have the effect of increasing overall deposition rate but, more significantly, may be used to increase uniformity of deposition (especially over relatively broad areas). With a relatively small ratio of jᵢ (e.g., 1-50mA/cm²) to deposition rates (e.g., 10-100 micrometers per minute) the deposition rates are defined mainly by evaporation rate (EB power) and not by ion bombardment. Ions are needed only for ion modification/enhancing of the deposited coatings (enhancing microstructure/density, adhesion, etc.) The non-uniform ion bombardment causes non-uniform properties of coatings. As is discussed below, also a spreading secondary plasma encourages relatively for spit-free deposition; via droplet elimination in large space between the crucible and the substrate.

The exemplary second anode 90 is a ring. The exemplary ring has an internal diameter D₂ which may be contrasted with an internal diameter D₁ of the first anode. The effect of the second anode 90 is stronger near its surface. Thus, the additional vapor ionization it provides is greater radially near the second anode 90 than near the axis 500 (or other center of the flowpath). This may have the effect of evening out (broadening/flattening) the transverse distribution of total ion current density and temperature and coating deposition distribution. The broadening/flattening of jᵢ does not directly affect coating thickness distribution; it affects the coating deposition conditions, including distribution of ion enhancing of coatings and elimination of spit/splash deposition on the broad substrate area. The more broad and more dense secondary plasma 104 (relative to diffusion plasma 102) ensures plasma evaporation of droplets/splashes on the flowpath from crucible to substrate. Thus, regulation of the operation of the second anode 90 may be used to provide a desired deposition condition uniformity. This may, for example, be achieved by measuring relative temperatures near the center and near the periphery and, increasing second anode voltage and/or duty cycle to increase relative peripheral temperature if desired (and vice versa). This may also be achieved by measuring secondary plasma density using plasma probes near the center and near the periphery of the substrate holder, or by measuring deposition rates with suitable sensors.

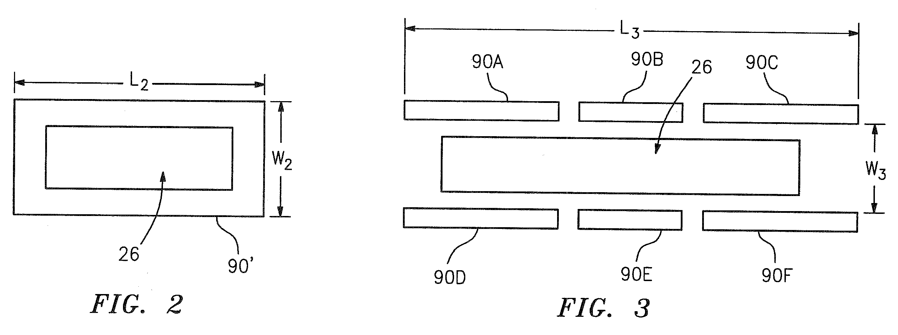

Because of the relationship between the second anode and the transverse coating distribution, it may be desirable to configure the second anode to correspond to the planform shape of the substrate being coated (or the group of substrates being coated). For example, FIG. 2 shows a plan view of an elongate (e.g., rectangular) substrate 26 and an alternate second anode 90'. However, this may alternatively represent the elongate (e.g., rectangular) planform outline of an array of smaller substrates being coated as a group. The characteristic transverse dimension D₂ is replaced by width and length W₂ and L₂. One can provide a desired deposition condition uniformity by modification of the second anode shape (e.g., via experimentation/optimization). The measurement of suitable parameters (e.g., secondary plasma density, near the center and near the periphery of the substrate holder) may be used for monitoring of the deposition condition uniformity.

In yet another alternative embodiment (FIG. 3), the second anode is represented by a group of second anodes which, in transverse projection, partially surround the perimeter of the substrate. To provide the individual anodes with water cooling, they may each be made from separate copper pipes and may have the shape of closed (or nearly closed) narrow rectangular rings so that the cooling water can flow around each ring. These may be powered in common (e.g., at the same voltage as each other by a single power supply) or may be individually powered by associated power supplies or may be powered in groups. The combination of powering may be chosen in view of the needs of uniformity. The measurement of suitable parameters (e.g., secondary plasma density, near the center and near the periphery of the substrate holder) may be used for monitoring of the deposition condition uniformity. The exemplary transverse dimensions of the space between these anodes are shown as W₃ and L₃.

Construction-wise, the exemplary second anode 90 may be formed as: one or more simple metal ring(s) (e.g., from copper pipe) or vertical metal plate(s); a vertically oriented spiral (coil-shaped); a circular ring with vertical zig-zag; or like a hamster wheel (with end rings joined by a circumferential array of links). The shape of this anode may be configured to provide effective generation of a large (extended) uniform secondary plasma. The second anode may be water-cooled or non-cooled. This may be distinguished from the first anode which may be of more simple shape, for example like a circular or rectangular metal ring or as a vertical metal plate(s). The first anode supports arc discharge on the liquid metal pool in the crucible and prevents arcing on the crucible body surface. The first anode may be water-cooled or non-cooled.

Exemplary process parameters may vary based upon the substrate material, deposition material, substrate geometry, and apparatus capacities. In an exemplary process, the first anode may be operated at a relatively low voltage magnitude (e.g., 5-20V to avoid cathode arc-type discharge on the crucible periphery and vapor). An exemplary inner diameter D₁ of the first anode is 100-300% of the crucible outer diameter, more narrowly, 150-200%.

The first anode operational regime was discussed above. Exemplary Dₐ₁ is in the vicinity of 0.5-0.99, more narrowly 0.8-0.99. This regime may be different from the first anode regime of US '734 to support the first plasma with minimal pause. This helps with arcing prevention and effective droplet plasma self-evaporation. The voltage and other parameters may be similar to those of US '734. The second anode operational regime is discussed below.

Whereas the size of the first anode is coupled to crucible/ingot parameters in view of the relatively low radial diffusion of vapor at that location, the transverse dimensions of the interior of a ring-like second anode or a space between a ring of second anodes is more tied to the planform of the workpiece or array of workpieces. These dimensions will likely be substantially greater than the transverse linear dimension (e.g., a diameter) of the first anodes. For example, exemplary transverse linear internal dimensions of the second anode (or array) are 150-200% (more broadly, 120-250%) of the aligned/adjacent transverse linear dimension of the substrate (or substrate array/group). Said transverse linear internal dimension of the second anode (or array) (D₂ and one or both of L₂ or W₂ (or one of both of L₃ and W₃)) may well be 200-1000% of a characteristic transverse linear internal dimension (D₁) of the first anode.

The second anode(s) may be powered by direct current power/voltage Uₐ₂. An exemplary magnitude of voltage Uₐ₂ is in the range of 100-5000V, more narrowly, 100-1000V whereby, according to the invention, Uₐ₂ is at least 1000% of the first anode voltage Uₐ₁. The second anode ionizing discharge may be also powered by pulsed direct current power and have a pulse rate (pulse repetition frequency) Fₐ₂, a pulse width τₐ₂, a duty cycle Dₐ₂=τₐ₂×Fₐ₂, and a peak current Iₐ₂.

The sensed parameters include those related to: the electron beams for evaporation and substrate heating (currents, voltages, parameters of beam scanning); ingot evaporation rate (may be measured defined by ingot feeding rate into the crucible; these parameters are proportional to each other) and/or deposition rate (the evaporation rate parameter gives information on deposition rate because these parameters are proportional to each other; primary arc discharge for vapor ionization, more specifically to the first anode regime (average or peak current Ia₁, duty cycle Dₐ₁ or pulse width τₐ₁, and a peak voltage Uₐ₁; Fₐ₁ (pulse rate) may be constant or Dₐ₁ may be equal to 1 in the non-modulated operation mode); secondary plasma, more specifically to the second anode regime (average or peak current Iₐ₂, duty cycle Dₐ₂ or pulse width τₐ₂, and a peak voltage Uₐ₂; Fₐ₂ (pulse rate) may be constant or Dₐ₂ may be equal to 1 in the non-modulated operation mode); negative substrate bias (duty cycle D_{b} or pulse width τ_{b}, and a peak voltage U_{b}, F_{b} (pulse rate) may be constant); substrate ion current (this current is close to the total current in the substrate circuit because the secondary electron emission current of the substrate surface under ion bombardment is much less than the substrate ion current; the total current is sum of bombarding ion and electron emission currents); and substrate temperature (it may be useful to measure temperature in different points when the substrate is of complex shape). For plasma monitoring, one or several plasma probes (probe array) may be used. The probe(s) may be located near the first anode and/or near the substrate at one or several points (the latter case is for monitoring of uniformity of deposition conditions). The output signals of the sensors go to the computer system for monitoring and control of deposition process parameters. Most of the parameters may be kept constant during deposition process but some of them (mainly duty cycle D_{b} or EB current for substrate heating) may be varied during deposition accordingly the deposition process procedure and feedback signals to provide a desired temperature regime of the substrate.

Various general techniques and specific methods of electrical and temperature measurements and different types of sensors/measuring devices (well known in electro-engineering, electronics, pulse techniques, plasma physics/techniques, thermophysics, etc.) employed for deposition processes monitoring may be used. The density of the primary and second plasmas (100 and 104) of the first and second ionizing discharges, accordingly, maybe monitored by a plasma probe or probe array 200-1, 200-2 (FIG. 1) within the chamber 24 and connected to a registration system 202 which may have output ports 204, 206 to permit monitoring (e.g., via either ammeter/voltmeter or an oscilloscope, or computer-based measuring digital device (which may be the control system 88 or a portion thereof)). An exemplary probe may be an electrode under negative potential relative to the plasma in order to measure the saturated ion current. By surrounding the path 522 with one or more arrays of probes, the spatial non uniformity of the ionizing discharges may be monitored. A plasma probe (or probe array 200-1) located in the vicinity of the first anode will monitor the first ionizing (initial) discharge (first plasma 100). A plasma probe (or probe array 200-2) located in the vicinity of the second anode will monitor the second ionizing discharge (secondary plasma 104). Spatial nonuniformity of plasmas may be caused by asymmetric heating of the pool by the electron beam and asymmetrical distribution of the first ionizing discharge over the pool, asymmetrical spatial distribution of the vapor stream, and by asymmetrical ionization from the secondary anode. The probes may be used for monitoring the spatial distribution of the vapor stream as well. The probes may be used both in ion enhanced EBPVD and conventional EBPVD to the extent that the evaporating electron beam 42 would provide some ionization of the vapor effective to generate current in the probe circuits. The current may be a proportion of the vapor density and evaporation rate. With pulse modulation of the ionizing discharge, probe current during the pulses may be used for discharge monitoring. Probe current between discharge pulses may be used for evaporation monitoring. The monitoring may allow quick detection of defects in the process and may provide for its stabilization via a feedback loop. For example, it is possible to stabilize the evaporation rate by control of the electron beam 42 so as to maintain constant probe current between pulses.

A pulse mode of second anode operation may be useful for prevention of arcing on substrate(s) and deposition chamber parts. Exemplary modulation parameters involve a frequency Fₐ₂ in the range of 0.05-150kHz, more narrowly 0.5-10kHz, and a duty cycle Dₐ₂ in the vicinity of 0.5-0.99, more narrowly 0.8-0.99. Various waveforms may be used alternatively to the square pulse. If pulse repetition frequencies Fₐ₁, Fₐ₂ and F_{b} are equal or at least divisable each to other, the pulses (Uₐ₁, Uₐ₂, U_{b}) with such frequencies may be synchronized as this may enhance prevention of arcing on the substrate and chamber wall surfaces. For instance, if F_{b}=Fₐ₂, then we have the same (synchronized) pauses in powering the substrate bias circuit and the second anode (second ionization discharge) that ensures total discontinue of the powering of a parasitic arc on the substrate and chamber wall surfaces (if such arcs have arisen) and favorable in break off of the arcing. If arcing has not arisen during the pulse, one may consider the probability of the arcing. Arcing is provoked when there are: 1) sufficient (high) plasma/ion density near a negatively biased surface (that ≡ plasma density or ~ to current Iₐ₂ of the second ionization discharge and is proportional to plasma density or current Iₐ₁ of the first ionization discharge); and 2) sufficient (high) voltage between the plasma and the surface (the voltage between the plasma and the substrate surface is sum of Uₐ₂ + U_{b}; the voltage between the plasma and the chamber wall surface is Uₐ₂). Thus, synchronized pauses in powering the substrate bias circuit (when U_{b} → 0) and the second anode (second ionization discharge) circuit (when Uₐ₂ → 0, Iₐ₂ → 0) may be used to prevent arcing. In an example not part of the claimed invention, the second anode(s) may be also powered by radio (high) frequency (0.1-100 MHz) or microwave (superhigh) frequency (e.g., 2.45 GHz) power. Such power supply may provide higher level of vapor ionization in conditions of low vapor pressure together with prevention of arcing.

Operation of the dual-anode system may be used to achieve spit reduction in deposited metal coatings such as are used in turbine element manufacture and repair (e.g., an MCrAlY used as a bondcoat for a thermal barrier coating (TBC) system or Ti-based material used for body repair of Ti-based turbine elements). This is relieved due to enhanced plasma self-evaporation of small droplets ejected from the melt pool via the splash effect.

For example, the ejected droplets have very high temperature (e.g., on the order of 2000C for the MCrAlY or Ti-based alloy). During droplet flight, they continue to evaporate. The primary and additional plasmas provided by the first and second anodes are believed to further heat the droplets to raise their temperature and cause further evaporation. The thermo-electron emission from the droplet surface with high temperature promotes collection of high energy plasma species (plasma electrons with high energy) due to the favorable effect of the emission on the droplet potential within the plasma. Intensive thermo-electron emission from the droplet surface leads to vanishing of droplet negative floating potential (moving it to positive side). In so doing, the intensity of its bombarding by plasma electrons (energy flux from plasma onto the droplet) is rapidly increased. This is accompanied by a rapid increase of droplet material evaporation rate. Ionization of metal vapor by plasma electrons near the droplet surface leads to formation of a vapor-plasma cloudlet around the droplet. Getting the energy from the surrounding discharge plasma, the droplet surface can effectively evaporate during droplet motion through plasma toward complete evaporation of the droplet. The second anode generates and heats the secondary plasma (it heats mainly plasma electrons). So, the longer the droplet path in plasma, the more enhanced the droplet evaporation is.

The broadening of the plasma provided by the second anode may allow yet further changes relative to a baseline system. For example, for the baseline system, the distance between the melt pool and the workpiece may be dictated by the desire to have a given transverse dimension of the vapor plume to provide a given deposition footprint. This imposes a minimum value for the separation. By effectively broadening the deposition footprint, this may allow for a reduction in the pool-to-workpiece separation. This separation reduction may allow a more compact deposition chamber and may increase deposition rates relative to deposition at a longer separation.

One or more embodiments have been described. Nevertheless, it will be understood that various modifications may be made. For example, although particularly useful with blades, the methods may be applied to other turbine parts and non-turbine parts. Details of the particular turbine engine part or other piece and the particular use and chemistry of the deposition material influence details of any given deposition. When implemented in the remanufacturing of an existing system or the reengineering of an existing system configuration, details of the existing system or configuration may influence details of any particular implementation. Accordingly, other embodiments are within the scope of the following claims.

## Claims

1. An apparatus (20) for depositing material on a workpiece (26) comprising:
a deposition chamber (22);
a deposition material source (32);
an electron beam source (44), positioned to direct a first electron beam (42) to vaporize a portion of the deposition material;
first means (60) for generating a primary plasma from said deposition material source (32);
second means (90) for generating a secondary plasma and further accelerating electrons from the primary plasma;
means (48) for applying a bias electric potential to the workpiece (26) to draw ions from the secondary plasma to the workpiece (26); and
a control system (88) coupled to the electron beam source (44), the means (60) for generating a primary plasma, the means (90) for generating a secondary plasma, and the means (48) for applying a bias potential, wherein the control system (88) is programmed to, in at least one mode:
operate the first means (60) at a first positive potential; and
operate the second means (90) at a second positive potential
; **characterised in that** said second positive potential is at least 1000% of the first positive potential.

2. The apparatus of claim 1, wherein the control system (88) is programmed to:
monitor density of at least one of the primary plasma and secondary plasma and an ion current to the workpiece (26); and
provide feedback loop control of deposition of the material.

3. The apparatus of claim 1 or 2 wherein:
the first means (60) is a first anode ring fully encircling a flowpath from the source (32) to the workpiece; and
the second means (90) is a second anode ring fully encircling the flowpath downstream of the first anode ring (60).

4. The apparatus of any preceding claim wherein the deposition material comprises an MCrAlY or a Ti based alloy.

5. The apparatus of claim 1 or 2, wherein said deposition material is at least partially within the deposition chamber (22), said first means comprises a first ionizing electrode (60) surrounding a flowpath from the deposition material, said second means comprises a second ionizing electrode (90) surrounding the flowpath downstream of the first electrode (60) and said apparatus further comprises an ionizing voltage source (62, 92) coupled to the first ionizing electrode (60) and the second ionizing electrode (90) to apply a first ionizing voltage to the first ionizing electrode (60) and a second ionizing voltage to the second ionizing electrode (90), wherein said means (48) for applying a bias electrical potential is a bias voltage source connected to apply an electric potential to the workpiece and said control apparatus is coupled to the bias voltage source (48) and the ionizing voltage source (62,92) and configured to, in at least a first operational condition, apply said first and second ionizing voltages of like sign and different magnitude.

6. The apparatus or claim 5 wherein:
the first ionizing electrode (60) comprises a circular ring; and
the second ionizing electrode (90) is formed other than as a circular ring, for example a non-circular ring (90') or a plurality of separately powered electrodes (90A-90F).

7. The apparatus of claim 5 or 6, wherein a source of the deposition material source comprises a crucible (36) and wherein:
a transverse linear internal dimension of the first ionizing electrode (60) is 100-300% of the crucible outer diameter; and
a transverse linear internal dimension of the second ionizing electrode (90) is 150-200% of a transverse linear dimension of the substrate and 200-1000% of a said transverse linear internal dimension of the first ionizing electrode (60).

8. The apparatus of any of claims 5 to 7, wherein the control apparatus (88) is programmed to control the bias voltage source so as to prevent arcing from the workpiece (26).

9. The apparatus of any of claims 5 to 8, wherein the bias voltage source (48) comprises an electronic tube acting to limit current to the workpiece.

10. The apparatus of any of claims 5 to 9, wherein the control apparatus (88) is coupled to the first and second ionizing electrodes (60,90) for pulse modulation of ionization.

11. A method for operating the apparatus of claim 10, the method comprising :
applying the first ionizing potential with:
a nominal voltage of 5V-50V;
a pulse repetition frequency of 1-10000Hz;
a duty cycle of 0.8-0.99; and
applying the second ionizing potential with:
a nominal voltage of 100V-1000V;
a pulse repetition frequency of 0.05-150kHz;
a duty cycle of 0.8-0.99.

12. The method of claim 11 comprising controlling the bias voltage source so as to apply the first potential with:
a nominal voltage of 50V-10kV, for example 1-3kV;
a pulse repetition frequency of 0.05-150kHz, for example 0.5-10kHz;
a pulse width of at least 5µs; and
a duty cycle of 0.1-0.99.

13. The method of claim 11 or 12, wherein:
the control apparatus is programmed to provide an ion current density of 1-50mA/cm2 at a deposition rate of 10-50µm/minute; and
the ion current density is 2-10mA/cm2 at a deposition rate of 15-20µm/minute.

## Patentansprüche

1. Vorrichtung (20) zum Abscheiden von Material auf einem Werkstück (26), die Folgendes umfasst:
eine Abscheidungskammer (22);
eine Abscheidungsmaterialquelle (32);
eine Elektronenstrahlquelle (44), die so angeordnet ist, dass ein erster Elektronenstrahl (42) zum Verdampfen eines Teils des Abscheidungsmaterials ausgerichtet ist;
ein erstes Hilfsmittel (60) zum Erzeugen eines Primärplasmas aus der Abscheidungsmaterialquelle (32);
ein zweites Hilfsmittel (90) zum Erzeugen eines Sekundärplasmas und ferner zum Beschleunigen von Elektronen aus dem Primärplasma;
ein Hilfsmittel (48) zum Anlegen eines elektrischen Biaspotentials auf das Werkstück (26), um Ionen aus den Sekundärplasma auf das Werkstück (26) zu ziehen; und
ein Steuersystem (88), das an die Elektronenstrahlquelle (44), das Hilfsmittel (60) zum Erzeugen eines Primärplasmas, das Hilfsmittel (90) zum Erzeugen eines Sekundärplasmas und das Hilfsmittel (48) zum Anlegen eines Biaspotentials angeschlossen ist, wobei das Steuersystem (88) so programmiert ist, dass es in mindestens einem Modus Folgendes ausführt:
Betreiben des ersten Hilfsmittels (60) bei einem ersten positiven Potential; und
Betreiben des zweiten Hilfsmittels (90) bei einem zweiten positiven Potential;
**dadurch gekennzeichnet, dass** das zweite positive Potential mindestens 1000 % des ersten positiven Potentials beträgt.

2. Vorrichtung nach Anspruch 1, wobei das Steuersystem (88) für Folgendes programmiert ist:
Überwachen der Dichte des Primärplasmas und/oder des Sekundärplasmas und eines lonenstroms zum Arbeitsstück (26); und
Bereitstellen einer Feedback-Schleifensteuerung der Abscheidung des Materials.

3. Vorrichtung nach Anspruch 1 oder 2, wobei:
das erste Hilfsmittel (60) ein erster Anodenring ist, der einen Strömungspfad von der Quelle (32) zum Werkstück vollständig umringt ist; und
das zweite Hilfsmittel (90) ein zweiter Anodenring ist, der den Strömungspfad vollständig umringt, der dem ersten Anodenring (60) nachgelagert ist.

4. Vorrichtung nach einem der vorhergehenden Ansprüche, wobei das Abscheidungsmaterial eine Legierung auf MCrAlY- oder Ti-Basis umfasst.

5. Vorrichtung nach Anspruch 1 oder 2,
wobei sich das Abscheidungsmaterial zumindest teilweise innerhalb der Abscheidungskammer (22) befindet, das erste Hilfsmittel eine erste lonisierungselektrode (60) umfasst, die einen Strömungspfad vom Abscheidungsmaterial umgibt, das zweite Hilfsmittel eine zweite lonisierungselektrode (90) umfasst, die den Strömungspfad umgibt, der der ersten Elektrode (60) nachgelagerten ist, und die Vorrichtung ferner eine lonisierungsspannungsquelle (62, 92) umfasst, die an die erste lonisierungselektrode (60) und die zweite lonisierungselektrode (90) angeschlossen ist, um eine erste lonisierungsspannung an die erste lonisierungselektrode (60) und eine zweite lonisierungselektrode an die Zweite lonisierungselektrode (90) anzulegen, wobei das Hilfsmittel (48) zum Anlegen eines elektrischen Biaspotentials eine Biasspannungsquelle ist, die zum Anlegen eines elektrischen Potentials an ein Werkstück angeschossen ist, und die Steuervorrichtung an die Biasspannungsquelle (48) und die lonisierungsspannungsquelle (62, 92) angeschlossen und so konfiguriert ist, dass die erste und zweite lonisierungsspannungen zumindest in einem ersten Betriebszustand mit gleichem Vorzeichen und unterschiedlicher Größe angelegt werden.

6. Vorrichtung nach Anspruch 5, wobei:
die erste lonisierungselektrode (60) einen Kreisring umfasst; und
die zweite lonisierungselektrode (90) eine andere Form als einen Kreisring aufweist, beispielsweise einen nicht kreisförmigen Ring (90') oder mehrere getrennt mit Strom versorgte Elektroden (90A-90F).

7. Vorrichtung nach Anspruch 5 oder 6, wobei eine Quelle der Abscheidungsmaterialquelle einen Tiegel (36) umfasst und wobei:
ein transversales lineares Innenmaß der ersten lonisierungselektrode (60) 100-300 % des Außendurchmessers des Tiegels beträgt; und
ein transversales lineares Innenmaß der zweiten lonisierungselektrode (90) 150-200 % eines transversalen linearen Maßes des Substrats und 200-1000 % des transversalen linearen Maßes der ersten lonisierungselektrode (60) beträgt.

8. Vorrichtung nach einem der Ansprüche 5 bis 7, wobei die Steuervorrichtung (88) so programmiert ist, dass sie die Biasspannungsquelle steuert, um eine Bogenbildung vom Werkstück (26) zu verhindern.

9. Vorrichtung nach einem der Ansprüche 5 bis 8, wobei die Biasspannungsquelle (48) eine elektronische Röhre umfasst, die den Strom zum Werkstück einschränkt.

10. Vorrichtung nach einem der Ansprüche 5 bis 9, wobei die Steuervorrichtung (88) zur Impulsmodulation der Ionisierung an die erste und zweite lonisierungselektrode (60, 90) angeschlossen ist.

11. Verfahren zum Betreiben der Vorrichtung nach Anspruch 10, wobei das Verfahren Folgendes umfasst:
Anlegen des ersten Ionisierungspotentials mit:
einer Nennspannung von 5 V-50 V;
einer Impulsfolgefrequenz von 1-10000 Hz;
einem Tastgrad von 0,8-0,99; und
Anlegen des zweiten Ionisierungspotentials mit:
einer Nennspannung von 100 V-1000 V;
einer Impulsfolgefrequenz von 0,05-150 kHz; einem Tastgrad von 0,8-0,99.

12. Verfahren nach Anspruch 11, das das Steuern der Biasspannungsquelle umfasst, um das erste Potential anzulegen mit:
einer Nennspannung von 50V-10kV, beispielsweise 1-3kV;
einer Impulsfolgefrequenz von 0,05-150 Hz, beispielsweise 0,5-10 kHz;
einer Impulsbreite von mindestens 5 µs; und
einem Tastgrad von 0,1-0,99.

13. Verfahren nach Anspruch 11 oder 12, wobei:
die Steuervorrichtung so programmiert ist, dass sie eine Ionenstromdichte von 1-50 mA/cm2 bei einer Abscheidungsgeschwindigkeit von 10-50 µm/Minute bereitstellt; und
die lonenstromdichte 2-10 mA/cm2 bei einer Abscheidungsgeschwindigkeit von 15-20 µm/Minute beträgt.

## Revendications

1. Appareil (20) pour déposer un matériau sur une pièce à travailler (26), comprenant :
une chambre de dépôt (22) ;
une source de matériau de dépôt (32) ;
une source de faisceau d'électrons (44), positionnée pour diriger un premier faisceau d'électrons (42) pour vaporiser une portion du matériau de dépôt ;
un premier moyen (60) pour générer un plasma primaire à partir de ladite source de matériau de dépôt (32) ;
un second moyen (90) pour générer un plasma secondaire et accélérer davantage des électrons à partir du plasma primaire ;
un moyen (48) pour appliquer un potentiel électrique de polarisation sur la pièce à travailler (26) pour attirer des ions à partir du plasma secondaire vers la pièce à travailler (26) ; et
un système de commande (88) couplé à la source de faisceau d'électrons (44), au moyen (60) pour générer un plasma primaire, au moyen (90) pour générer un plasma secondaire, et au moyen (48) pour appliquer un potentiel de polarisation, dans lequel le système de commande (88) est programmé pour, dans au moins un mode :
faire fonctionner le premier moyen (60) à un premier potentiel positif ; et
faire fonctionner le second moyen (90) à un second potentiel positif ;
**caractérisé en ce que** ledit second potentiel positif est au moins 1 000 % du premier potentiel positif.

2. Appareil selon la revendication 1, dans lequel le système de commande (88) est programmé pour :
surveiller la densité d'au moins un parmi le plasma primaire et le plasma secondaire et un courant ionique vers la pièce à travailler (26) ; et
fournir une commande en boucle à réaction de dépôt du matériau.

3. Appareil selon la revendication 1 ou 2 dans lequel :
le premier moyen (60) est une première anode annulaire encerclant entièrement un trajet de flux de la source (32) à la pièce à travailler ; et
le second moyen (90) est une seconde anode annulaire encerclant entièrement le trajet de flux en aval de la première anode annulaire (60).

4. Appareil selon une quelconque revendication précédente, dans lequel le matériau de dépôt comprend un MCrAlY ou un alliage à base de Ti.

5. Appareil selon la revendication 1 ou 2, dans lequel ledit matériau de dépôt se trouve au moins partiellement à l'intérieur de la chambre de dépôt (22), ledit premier moyen comprend un première électrode d'ionisation (60) entourant un trajet de flux à partir du matériau de dépôt, ledit second moyen comprend une seconde électrode d'ionisation (90) entourant le trajet de flux en aval de la première électrode (60) et ledit appareil comprend en outre une source de tension d'ionisation (62, 92) couplée à la première électrode d'ionisation (60) et à la seconde électrode d'ionisation (90) pour appliquer une première tension d'ionisation sur la première électrode d'ionisation (60) et une seconde tension d'ionisation sur la seconde électrode d'ionisation (90), dans lequel ledit moyen (48) pour appliquer un potentiel électrique de polarisation est une source de tension de polarisation connectée pour appliquer un potentiel électrique sur la pièce à travailler et ledit appareil de commande est couplé à la source de tension de polarisation (48) et à la source de tension d'ionisation (62, 92) et configuré pour, dans au moins une première condition de fonctionnement, appliquer lesdites première et seconde tensions d'ionisation de signe identique et d'amplitude différente.

6. Appareil selon la revendication 5, dans lequel :
la première électrode d'ionisation (60) comprend un anneau circulaire ; et
la seconde électrode d'ionisation (90) présente une forme autre qu'un anneau circulaire, par exemple un anneau non circulaire (90') ou une pluralité d'électrodes alimentées séparément (90A-90F).

7. Appareil selon la revendication 5 ou 6, dans lequel une source de la source de matériau de dépôt comprend un creuset (36) et dans lequel :
une dimension interne linéaire transversale de la première électrode d'ionisation (60) est 100 à 300 % du diamètre extérieur de creuset ; et
une dimension interne linéaire transversale de la seconde électrode d'ionisation (90) est 150 à 200 % d'une dimension linéaire transversale du substrat et 200 à 1 000 % d'une dite dimension interne linéaire transversale de la première électrode d'ionisation (60).

8. Appareil selon l'une quelconque des revendications 5 à 7, dans lequel l'appareil de commande (88) est programmé pour commander la source de tension de polarisation afin d'empêcher la formation d'arc à partir de la pièce à travailler (26).

9. Appareil selon l'une quelconque des revendications 5 à 8, dans lequel la source de tension de polarisation (48) comprend un tube électronique agissant pour limiter un courant sur la pièce à travailler.

10. Appareil selon l'une quelconque des revendications 5 à 9, dans lequel l'appareil de commande (88) est couplé aux première et seconde électrodes d'ionisations (60, 90) pour la modulation d'impulsion d'ionisation.

11. Procédé pour faire fonctionner l'appareil selon la revendication 10, le procédé comprenant :
l'application du premier potentiel d'ionisation avec :
une tension nominale de 5 V à 50 V ;
une fréquence de répétition d'impulsion d'1 à 10 000 Hz ;
un cycle de service de 0,8 à 0,99 ; et
l'application du second potentiel d'ionisation avec :
une tension nominale de 100 V à 1 000 V ;
une fréquence de répétition d'impulsion de 0,05 à 150 kHz ;
un cycle de service de 0,8 à 0,99.

12. Procédé selon la revendication 11 comprenant la commande de la source de tension de polarisation afin d'appliquer le premier potentiel avec :
une tension nominale de 50 V à 10 kV, par exemple 1 à 3 kV ;
une fréquence de répétition d'impulsion de 0,05 à 150 kHz, par exemple 0,5 à 10 kHz ;
une durée d'impulsion d'au moins 5 µs ; et
un cycle de service de 0,1 à 0,99.

13. Procédé selon la revendication 11 ou 12, dans lequel :
l'appareil de commande est programmé pour fournir une densité de courant ionique de 1 à 50 mA/cm2 à un taux de dépôt de 10 à 50 µm/minute ; et
la densité de courant ionique est 2 à 10 mA/cm2 à un taux de dépôt de 15 à 20 µm/minute.
